# EUROPEAN PATENT APPLICATION

(11) **EP 4 459 401 A1**
(43) Date of publication of application: **06.11.2024**
(21) Application number: 22914467.0
(22) Date of filing: 21.12.2022
(51) Int. Cl.: G05B 23/02

(54) **MULTI-ECU SIMULATION TEST METHOD AND APPARATUS, COMPUTER DEVICE, AND STORAGE MEDIUM**

(30) Priority: 27.12.2021 CN 202111619176
(71) Applicant: Beijing Co Wheels Technology Co., Ltd, Beijing 101300 (CN)
(72) Inventor: ZHENG, Xiaoxi, Beijing 101300 (CN)
(74) Representative: advotec.
(86) International application number: PCT/CN2022/140837
(87) International publication number: WO 2023/125213

(57) **Abstract**

Disclosed is a multi-ECU simulation test method, comprising: obtaining a pre-developed application applied to a target ECU; inputting the application into a pre-built multi-ECU simulation environment; querying, in the multi-ECU simulation environment, a simulated vehicle-mounted ECU having the same unique identifier as the target ECU to obtain a target simulated ECU; and simulating a communication process of the target simulated ECU by means of a simulated controller area network or a simulated Internet network in the multi-ECU simulation environment, running the application on the basis of the target simulated ECU, and outputting a running result of the application.

## Description

### CROSS REFERENCE TO RELATED APPLICATIONS

This application is based on and claims priority to Chinese patent application No. 202111619176.1, filed on December 27, 2021, the entire contents of which are incorporated herein by reference.

### TECHNICAL FIELD

The disclosure relates to a field of vehicle-mounted electronic control unit (ECU) technologies, in particular to a multi-ECU simulation test method, a multi-ECU simulation test apparatus, a computer device and a storage medium.

### BACKGROUND

A typical network topology of an integrated electrical/electronic architecture contains a Controller Area Network (CAN), a CAN with Flexible Data-Rate (CANFD), a Local Interconnect Network (LIN), an Ethernet and other communications. When an application with certain functions is developed for use in a vehicle-mounted ECU, the effectiveness of the application needs to be tested. An existing testing method is to purchase and use a CAN open environment (CANoe) and a CANCaseXL (which is a vector hardware interface card). On the other hand, currently, when the application is tested through a variety of simulation test products, and developers need to collaborate on development and testing, since there are limited number of software and hardware test device used for testing, and the testing of the application by multiple parties involves a lot of physical devices, it is difficult to perform cross-platform simulation, development and testing independently.

### SUMMARY

Embodiments of the disclosure provide a multi-electronic control unit (ECU) simulation test method, a multi-ECU simulation test apparatus, a computer device, a storage medium, a computer program product and a computer program, to solve a technical problem that a cross-platform simulation test of a same application developed for ECUs cannot be independently completed.

The embodiments of the disclosure provide a multi-ECU simulation test method, which is applied to a computer device. The method includes:
obtaining a pre-developed application applied to a target ECU;
inputting the application into a pre-built multi-ECU simulation environment;
obtaining a target simulated ECU by querying a simulated vehicle-mounted ECU having a unique identifier the same as the target ECU in the multi-ECU simulation environment; and
simulating a communication process of the target simulated ECU via a simulated controller area network (CAN) or a simulated Internet network in the multi-ECU simulation environment, running the application based on the target simulated ECU, and outputting a running result of the application.

The embodiments of the disclosure also provide a multi-ECU simulation test apparatus. The apparatus includes:
an application obtaining module, configured to obtain a pre-developed application applied to a target ECU;
an inputting module, configured to input the application into a pre-built multi-ECU simulation environment;
a querying module, configured to obtain a target simulated ECU by querying, in the multi-ECU simulation environment, a simulated vehicle-mounted ECU having a unique identifier the same as the target ECU; and
a running module, configured to simulate a communication process of the target simulated ECU via a simulated CAN or a simulated Internet network in the multi-ECU simulation environment, run the application based on the target simulated ECU, and output a running result of the application.

The embodiments of the disclosure also provide a computer device including a memory, a processor, and computer programs stored on the memory and executable by the processor. When the computer programs are executed by the processor, the steps of the multi-ECU simulation test method are implemented.

The embodiments of the disclosure also provide a computer-readable storage medium having computer programs stored thereon. When the computer programs are executed by a processor, the steps of the multi-ECU simulation test method are implemented.

The embodiments of the disclosure also provide a computer program product including computer programs. When the computer programs are executed by a processor, the above multi-ECU simulation test method is implemented.

The embodiments of the disclosure also provide a computer program including computer program codes. When the computer program codes are executed by a computer, the computer is caused to perform the above multi-ECU simulation test method.

According to the multi-ECU simulation test method, the multi-ECU simulation test apparatus, the computer device, the storage medium, the computer program product and the computer program provided by the disclosure, the application to be tested is input into the pre-built multi-ECU simulation environment. The target simulated ECU is obtained by querying, in the multi-ECU simulation environment, the simulated vehicle-mounted ECU having the same unique identifier as the target ECU. The target simulated ECU runs the application and outputs the running result of the application. Since the multi-ECU simulation environment is capable of simulating the CAN and the Internet network, the target simulated ECU can be obtained from simulated vehicle-mounted ECUs. Whether the application to be tested is applied to one target ECU or involves to data interaction between multiple target ECUs, it can be tested through this multi-ECU simulation environment. Therefore, a cross-platform simulation test of the application to be tested can be independently completed in a simulation environment, thereby improving an efficiency of simulation test while reducing a cost of the simulation test.

### BRIEF DESCRIPTION OF THE DRAWINGS

In order to more clearly illustrate the technical solutions in the embodiments of the disclosure, the following will briefly introduce the accompanying drawings that need to be used in the description of the embodiments of the disclosure. Obviously, the accompanying drawings in the following description are some embodiments of the disclosure, and it is possible for those skilled in the art to obtain other drawings based on the drawings without inventive work.
FIG. 1 is a schematic diagram of an application environment of a multi-ECU simulation test method of an embodiment of the disclosure.
FIG. 2 is a flowchart of a multi-ECU simulation test method of an embodiment of the disclosure.
FIG. 3 is a schematic diagram of a network topology of a multi-ECU simulation environment of an embodiment of the disclosure.
FIG. 4 is a schematic diagram of a simulated ECU connected on a topic of a multi-ECU simulation environment of an embodiment of the disclosure.
FIG. 5 is a block diagram of a multi-ECU simulation test apparatus of an embodiment of the disclosure.
FIG. 6 is a block diagram of a computer device of an embodiment of the disclosure.

### DETAILED DESCRIPTION

The technical solutions in the embodiments of the disclosure will be described clearly and completely in the following in combination with the accompanying drawings in the embodiments of the disclosure. Obviously, the described embodiments are a part of the embodiments of the disclosure, and not all of the embodiments. Based on the embodiments in the disclosure, all other embodiments obtained by those skilled in the art without inventive work fall within the scope of protection of the disclosure.

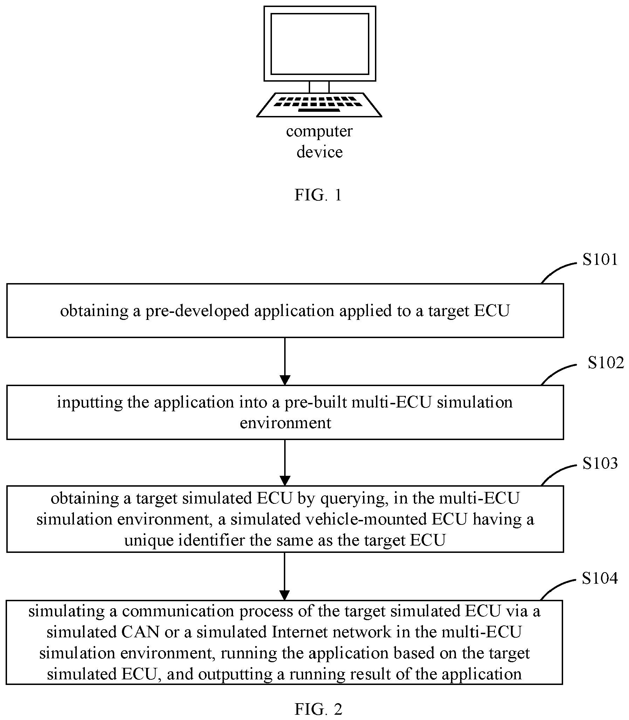

The multi-ECU simulation test method provided by the disclosure can be applied to an application environment shown in FIG. 1. The computer device is capable of communicating with other devices via a network. The computer device may include, but is not limited to, a personal computer, a laptop, a smartphone, a tablet, and the like.

In an embodiment, as shown in FIG. 2, a multi-electronic control unit (ECU) simulation test method is provided. The method is illustrated by taking the method applied to the computer device in FIG. 1 as an example, and the method includes the following steps S101 to S104.

At step S101, a pre-developed application applied to a target ECU is obtained.

In an embodiment, the target ECU represents a physical ECU installed on a vehicle. The application of the target ECU may be an application with certain functions applied to the physical ECU or a diagnostic program for diagnosing the target ECU.

At step S102, the application is input into a pre-built multi-ECU simulation environment. The multi-ECU simulation environment includes at least one Diagnostic On IP (DoIP, which is a communication rule that applies an IP technology to a vehicle-mounted network diagnose) simulation node and a number of simulated vehicle-mounted ECUs, each simulated vehicle-mounted ECU performs communication via a simulated CAN bus or a simulated DoIP network based on the DoIP simulation node.

It is understood that one DoIP simulation node is used to simulate a virtual network of an IP address. Since a DoIP protocol stack is based on a Transmission Control Protocol (TCP)/ Internet Protocol (IP) and a User Datagram Protocol (UDP) and has a cross-platform characteristic, by applying the DoIP protocol stack technology in the multi-ECU simulation environment, different IP addresses can be simulated through a docker virtual network on a single-machine Linux platform, so as to enable each simulated vehicle-mounted ECU to start in different dockers, so that different simulated vehicle-mounted ECUs in the same multi-ECU simulation environment can have different IP addresses. Communicating through a DoIP node message generated between the simulated vehicle-mounted ECUs with different IP addresses is implemented as follows: a destination address is converted to an IP address or a docker name in a virtual network, and management is performed through docker-compose. The conversion command may be, for example:
docker network create -d bridge ecu-bridge ;
docker run -d --name Node1 --network ecu-bridge mydocker:latest /bin/bash -c -v;
docker run -d --name Node2 --network ecu-bridge mydocker:latest /bin/bash -c -v.

In an embodiment, pre-building the multi-ECU simulation environment includes the following steps (1) to (4).
(1) A data link layer and a physical layer of the simulated Internet network are configured based on a received first instruction.
   In detail, according to requirements of ISO-13400, DoIP communication needs to be configured to support two standards, i.e., 100BASE-TX (100 Mbit/s Ethernet) and 10BASE-T (10 Mbit/s Ethernet), at the physical layer.
(2) A transport layer and a network layer of the simulated Internet network are configured based on a received second instruction and an IP stack.
   In detail, the IP stack, i.e., the DoIP protocol stack, needs to configure a Media Access Control (MAC) address for a DoIP device that is comply with the requirements of Ethernet IEEE 802.3. The communication supports both the UDP and the TCP on the transport layer and uses an IPv6 protocol on the network layer, and it also supports an IPv4 protocol for backward compatibility reasons. In addition, it is configured to support an Address Resolution Protocol (ARP). For the IPv6 protocol, it also needs to support a Neighbor Discovery Protocol (NDP). These two protocols are used to obtain the MAC address when only the IP address is known.
(3) A CAN bus communication is simulated based on a received third instruction and data distribution service DDS (such as Direct Digital Synthesis).

The features of the CAN communication include: carrier sense multiple access with conflict avoidance (CSMA/CA), transmission of messages by broadcasting without depending on a particular destination address, error detection, self-recovery, and high reliability.

Through the above features, the sending and receiving of messages on the CAN bus can be replaced by a Subscriber (SUB)/Publisher (PUB) operation of a TOPIC, where each node sends the message to be sent to the CAN bus through the PUB, and at the same time filters the data to the SUB. A communication priority arbitration policy and a communication reliability policy can be simply implemented by configuring a Quality of Service (QOS).

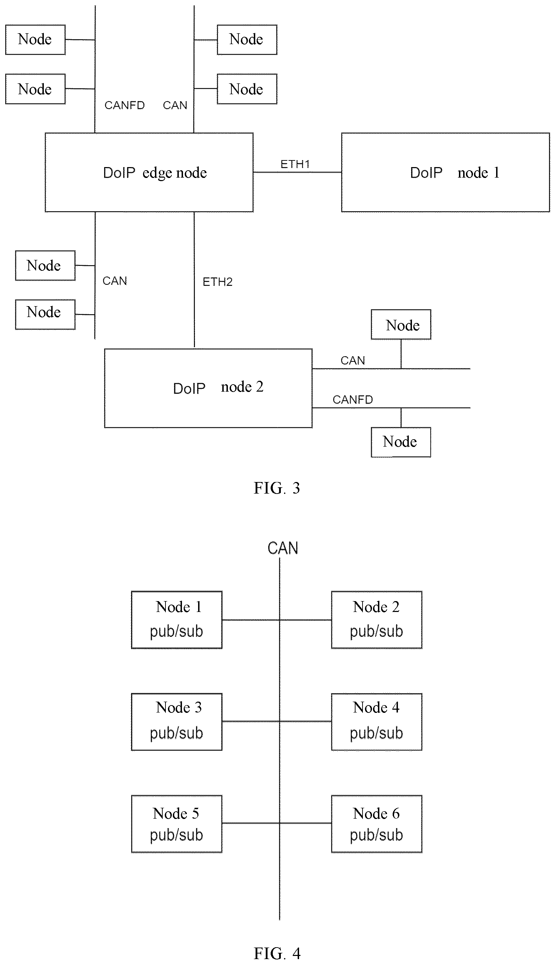

FIG. 4 is a schematic diagram of a simulated ECU connected on a topic of a multi-ECU simulation environment of an embodiment of the disclosure. As illustrated in FIG. 4, nodes belonging to the same TOPIC are connected by a line. Each node in FIG. 4 represents a corresponding simulated vehicle-mounted ECU, and each of the simulated vehicle-mounted ECUs corresponds to a respective simulated physical vehicle-mounted ECU.

(4) Virtual network corresponding respectively to IP simulation addresses where the simulated vehicle-mounted ECUs are located are configured based on a received fourth instruction.

It should be understood that after building the multi-ECU simulation environment, a corresponding configuration file needs to be imported according to an actual test scenario of the multi-ECU simulation environment. For example, when the vehicle-mounted ECU needs to be diagnosed, the CANdelaStudio (CDD, which is a diagnostic explanation)/Open Diagnostic data eXchange (ODX) configuration file needs to be imported. When a CAN broadcasting function of a certain application needs to be tested, for example, intelligently detecting whether a window/door is closed, a Database CAN (DBC, which is a database file of the CAN) configuration file needs to be imported. In addition, a lua configuration file can be imported to configure basic parameters of the ECU and a node state of the entire network, in order to assist in completing establishment of the simulation environment. Preferably, the lua configuration file, the CDD/ODX configuration file, and the DBC configuration file may all be imported into the multi-ECU simulation environment.

The currently developed business function of the ECU is self-tested through the built multi-ECU simulation environment. A development iteration process can be accelerated by writing test cases in the simulation environment.

At step S103, a target simulated ECU is obtained by querying, in the multi-ECU simulation environment, a simulated vehicle-mounted ECU having the same unique identifier as the target ECU.

FIG. 3 is a schematic diagram of a network topology of a multi-ECU simulation environment of an embodiment of the disclosure. As illustrated in FIG. 3, each node in FIG. 3 represents a corresponding simulated vehicle-mounted ECU, and each of the simulated vehicle-mounted ECUs corresponds to a respective physical vehicle-mounted ECU. The DoIP node represents a simulated DoIP network in a virtual network, and each DoIP node or DoIP edge node has its own IP address. Each simulated vehicle-mounted ECU performs communication via a simulated CAN bus or a simulated DoIP network based on the DoIP simulation node (i.e., ETH in Figure 3).

The applications to be tested can be classified into two main categories by function, one refers to development related to communication on a physical bus and the other refers to development of business logic. This embodiment focuses on the development of communication logic on a simulated physical bus, so that a simulation environment of an application layer is not limited to hardware devices such as CANCaseXL, and engineers that develop the application can focus more on rapid business iteration and accelerate development efficiency as developing a conventional application (APP).

When the application to be tested is tested in the multi-ECU simulation environment, firstly, it is necessary to know to which physical ECU the application to be tested is applied, so as to facilitate querying, in the simulation environment, a corresponding target simulated ECU according to the unique identifier of the target ECU. The application is tested based on the target simulated ECU, and it is possible to predict the effectiveness of the application running on the physical ECU.

At step S 104, a communication process of the target simulated ECU is simulated via a simulated CAN or a simulated Internet network in the multi-ECU simulation environment, the running of the application is implemented based on the target simulated ECU, and a running result of the application is output.

In an embodiment, when there are a plurality of target ECUs to which the application is applied, and there is only one IP address for the plurality of target ECUs, running the application based on the target simulated ECU, includes:
obtaining a first message sent to the simulated CAN;
obtaining a simulated ECU of a sending object of the first message from the first message; and
replacing the first message with a source transmit code of a topic to which the simulated ECU of the sending object belongs. This source transmit code can be a PUB transmit code.

In an embodiment, when there are a plurality of target ECUs to which the application is applied, and there are two or more IP addresses for the plurality of target ECUs, running the application based on the target simulated ECU, includes:
obtaining a destination address of a second target simulated ECU in a simulated Internet network message sent by a first target simulated ECU;
converting the destination address to a target Internet network simulation address (i.e., target IP simulation address) in the simulated Internet network; and
sending the simulated Internet network message to the second target simulated ECU corresponding to the target IP simulation address.

Simulation of the Internet network can be achieved by constructing a DoIP simulation node in the multi-ECU simulation environment.

In the embodiment of the disclosure, there is proposed an implementation means of running the application through the target simulated ECU when there are a plurality of target ECUs to which the application is applied and there are one IP address or two or more IP addresses for the plurality of target ECUs. Therefore, regardless of the actual environment in which the application is applied, data related to the application can be sent and received through the multi-ECU simulation environment and the test of the application is realized based on the same computer device and the same simulation environment.

In an embodiment, the application includes a diagnostic file, running the application based on the target simulated ECU and outputting the running result of the application, includes:
importing the diagnostic file into the target simulated ECU;
obtaining an execution result of executing the diagnostic file by the target simulated ECU; and
determining whether the execution result contains a diagnostic fault code or a corresponding error text, and if so, determining that the target simulated ECU is operating abnormally.

This diagnostic file includes a CDD/ODX file.

In the embodiment, the diagnostic file in a format of CDD or ODX is parsed, to realize a diagnostic interface for the ECU. The diagnostic file contains a communication protocol for diagnosis and required communication parameters, a diagnostic service and its format/sub-function on the ECU, a Data Identifier (DID) and an interpreted code value, a Diagnostic Trouble Code (DTC) and a corresponding error text.

In an embodiment, running the application based on the target simulated ECU and outputting the running result of the application, includes:
importing the application into the target simulated ECU;
obtaining an execution result of executing the application by the target simulated ECU; and
outputting a function status parameter of the target simulated ECU carried in the execution result.

An application suitable for this embodiment may be, for example, an application for controlling a moving direction of a car window. In this case, the output execution result carries a function status parameter of the target simulated ECU. For example, the function status parameter may be 00, 01 and 11, in which 00 indicates that the window status is raising up, 01 indicates that the window status is going down, and 11 indicates that the window status is stationary.

In other embodiments, the application suitable for the embodiment may also be an application for controlling a change in a volume of a speaker in the vehicle, a vehicle brake control application, and the like.

In an embodiment, running the application based on the target simulated ECU, includes:
parsing a first file in a DBC format generated by the target simulated ECU based on the application; and
broadcasting a message generated based on the first file in the simulated CAN in accordance with an information cycle recorded in the first file.

It is understood that parsing the first file in the DBC format makes it possible to test, by configuring a customized value of a signal via lua, the message sent on the CAN bus based on the information cycle in the DBC.

In other embodiments, when the application, e.g., an application for controlling the change in the volume of the speaker in a vehicle, a vehicle brake control application, or an application for controlling vehicle windows, requires simulated Internet communication between different target simulated ECUs, the simulation of the Internet network needs to be implemented by constructing the DoIP simulation node in the multi-ECU simulation environment in advance.

In an embodiment, after step S104, the method further includes:
in response to an expectation of the running result being satisfied, determining whether the application is correct; and in response to the expectation of the running result not being satisfied, sending a prompt message indicating that the application needs to be fixed.

It is understood that each application to be tested has a corresponding expectation, for example, popping up a certain window, controlling the window to raise up, controlling the window to go down, and controlling the headlight to be turned on/off. When the running result of a certain application to be tested does not meet the expectation, it indicates that the application to be tested may have a program error and needs to be fixed.

In an embodiment, the prompt message is output, for example, by popping up an alert box, sending an error code, emitting a beep sound and so on.

According to the multi-ECU simulation test method provided in the embodiment, firstly, the application to be tested is input into the pre-built multi-ECU simulation environment. The target simulated ECU is obtained by querying, in the multi-ECU simulation environment, the simulated vehicle-mounted ECU having the same unique identifier as the target ECU. The target simulated ECU runs the application and outputs the running result of the application. It can be determined whether the application is correct or not according to the running result. Since the multi-ECU simulation environment includes at least one DoIP simulation node and a plurality of simulated vehicle-mounted ECUs, each of the simulated vehicle-mounted ECUs performs communication via a simulated CAN bus or a simulated DoIP network based on the DoIP simulation node. Therefore, regardless of whether the application to be tested is applied to one target ECU or involves to data interaction between multiple target ECUs, it can be tested through this multi-ECU simulation environment, so that a cross-platform simulation test of the application to be tested can be independently completed in one simulation environment, thereby improving an efficiency of simulation test while reducing a cost of simulation test.

It is difficult for a traditional distributed electrical/electronic architecture to bear the complex functions of the vehicle, and it is gradually evolving to a centralized electrical/electronic architecture. That is, by independently developing an underlying operating system, and using a central processor to uniformly mange different domain processors and ECUs, the internal structure is simplified. Meanwhile, vehicle-mounted Ethernet is starting to replace the bus structures of CAN and LIN in some domains. On the one hand, the complexity of in-vehicle wiring harness is reduced, and on the other hand, the versatility and portability are greatly improved. The multi-ECU simulation test method proposed in the embodiment can be detached from CANoe, CANCaseXL and other hardware and software, and can quickly build the cross-platform simulation, development and test environment, to improve the efficiency of development iteration. Meanwhile, all of the functions of the ECU during development iteration can be quickly validated and full-flow test cases can be built in a cross-platform x86 environment, so as to improve the quality of code.

It should be understood that the serial numbers of the steps in the above-described embodiments does not imply the order of execution, and the order of execution of the processes should be determined by their functions and inherent logic without constituting any limitation of the process of implementing the embodiments of the disclosure.

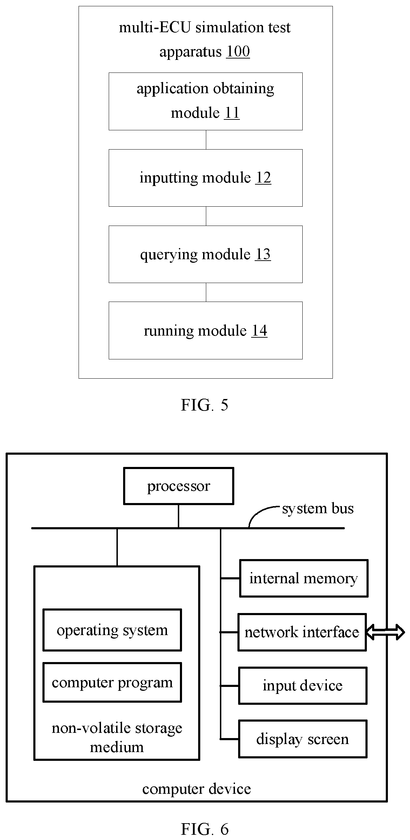

In an embodiment, a multi-ECU simulation test apparatus is provided. The apparatus corresponding to the above method respectively. As shown in FIG. 5, the apparatus 100 includes: an application obtaining module 11, an inputting module 12, a querying module 13, and a running module 14. Each functional module is described in detail below.

The application obtaining module 11 is configured to obtain a pre-developed application applied to a target ECU.

The inputting module 12 is configured to input the application into a pre-built multi-ECU simulation environment.

The querying module 13 is configured to obtain a target simulated ECU by querying, in the multi-ECU simulation environment, a simulated vehicle-mounted ECU having a unique identifier the same as the target ECU.

The running module 14 is configured to simulate a communication process of the target simulated ECU via a simulated CAN or a simulated Internet network in the multi-ECU simulation environment, run the application based on the target simulated ECU, and output a running result of the application.

With the multi-ECU simulation test apparatus provided by the embodiment, the inputting module 12 inputs the application to be tested into the pre-built multi-ECU simulation environment. The querying module 13 queries, in the multi-ECU simulation environment, the simulated vehicle-mounted ECU having the same unique identifier as the target ECU, to obtain the target simulated ECU. The running module 14 runs the application and outputs the running result of the application through the target simulated ECU. Since the multi-ECU simulation environment includes at least one DoIP simulation node and a plurality of simulated vehicle-mounted ECUs, each of the simulated vehicle-mounted ECUs performs communication via a simulated CAN bus or a simulated DoIP network based on the DoIP simulation node. Therefore, regardless of whether the application to be tested is applied to one target ECU or involves to data interaction between multiple target ECUs, it can be tested through this multi-ECU simulation environment, so that a cross-platform simulation test of the application to be tested can be independently completed in a simulation environment, thereby improving an efficiency of simulation test while reducing a cost of the simulation test.

In an embodiment, the apparatus 100 further includes:
a first configuring module, configured to configure a data link layer and a physical layer of the simulated Internet network based on a received first instruction;
a second configuring module, configured to configure a transport layer and a network layer of the simulated Internet network based on a received second instruction and an IP stack;
a communication simulating module, configured to simulate a CAN bus communication based on a received third instruction and data distribution service; and
a third configuring module, configured to configure virtual networks corresponding respectively to IP simulation addresses where the simulated vehicle-mounted ECUs are located based on a received fourth instruction.

It should be understood that after building the multi-ECU simulation environment, a corresponding configuration file needs to be imported according to an actual test scenario of the multi-ECU simulation environment. For example, when the vehicle-mounted ECU needs to be diagnosed, the CDD/ODX configuration file needs to be imported. When a CAN broadcasting function of a certain application needs to be tested, for example, intelligently detecting whether a window/door is closed, a DBC configuration file needs to be imported. In addition, a lua configuration file can be imported to configure basic parameters of the ECU and the nodes state of the entire network, in order to assist in completing establishment of the simulation environment. Preferably, the lua configuration file, the CDD/ODX configuration file, and the DBC configuration file may all be imported into the multi-ECU simulation environment.

The currently developed business functions of the ECU are self-tested through the built multi-ECU simulation environment. A development iteration process can be accelerated by writing test cases in the simulation environment.

In an embodiment, when there are a plurality of target ECUs to which the application is applied, and there is only one IP address for the plurality of target ECUs, the running module 14 includes:
a first message sending unit, configured to obtain a first message sent to the simulated CAN;
an object obtaining unit, configured to obtain a simulated ECU of a sending object of the first message from the first message; and
a replacing unit, configured to replace the first message with a source transmit code of a topic to which the simulated ECU of the sending object belongs.

In an embodiment, when there are a plurality of target ECUs to which the application is applied, and there are two or more IP addresses for the plurality of target ECUs, the running module 14 includes:
an address obtaining unit, configured to obtain a destination address of a second target simulated ECU in a simulated Internet network message sent by a first target simulated ECU;
an address replacing unit, configured to convert the destination address to a target IP simulation address in the simulated Internet network; and
a node message sending unit, configured to send the simulated Internet network message to the second target simulated ECU corresponding to the target IP simulation address.

In the embodiment, there is proposed the implementation means of running the application through the target simulated ECU when there are a plurality of target ECUs to which the application is applied and there are one IP address or two or more IP addresses for the plurality of target ECUs, so that regardless of the actual environment in which the application is applied, data related to the application can be sent and received through the multi-ECU simulation environment and the test of the application based on the same computer device and the same simulation environment can be realized.

In an embodiment, the application includes a diagnostic file, the running module 14 includes:
a first importing unit, configured to import the diagnostic file into the target simulated ECU;
a diagnostic result obtaining unit, configured to obtain an execution result of executing the diagnostic file by the target simulated ECU; and
a diagnosing unit, configured to determine whether the execution result contains a diagnostic fault code or a corresponding error text, and if so, determine that the target simulated ECU is operating abnormally.

In an embodiment, this diagnostic file includes a CDD/ODX file.

The running module 14 includes:
a second importing unit, configured to import the application into the target simulated ECU;
an execution result obtaining unit, configured to obtain an execution result of executing the application by the target simulated ECU; and
a parameter outputting unit, configured to output a function status parameter of the target simulated ECU carried in the execution result.

The embodiment parses the diagnostic file in a format of CDD or ODX, to realize a diagnostic interface for the ECU. The diagnostic file contains a communication protocol for diagnosis and required communication parameters, a diagnostic service and its format/sub-function on the ECU, a DID and an interpreted code value, a DTC and a corresponding error text.

In an embodiment, the running module 14 includes:
a parsing unit, configured to parse a first file in a DBC format generated by the target simulated ECU based on the application; and
a broadcasting unit, configured to broadcast a message generated based on the first file in the simulated CAN in accordance with an information cycle recorded in the first file.

The terms "first" and "second" in the above modules/units are only used to distinguish between different modules/units and are not intended to indicate which module/unit has a higher priority or has other defining meanings. In addition, the terms "including" and "having" and any variations thereof, are intended to cover non-exclusive inclusion, e.g., a process, method, system, product or apparatus comprising a series of steps or modules need not be limited to those steps or modules clearly listed, but other steps or modules that are not clearly listed or are inherent to the process, method, product or apparatus. The modules in this disclosure are classified only by logic, and there may be other ways of classifying the modules when implemented in practical applications.

The multi-ECU simulation test apparatus can be specifically limited with reference to the limitations on the multi-ECU simulation test method described above, and will not be repeated herein. The modules of the above multi-ECU simulation test apparatus may be realized in whole or in part by means of software, hardware and combinations thereof. Each of the above modules may be embedded in or independently of the processor of the computer device in the form of hardware, or may be stored in the memory of the computer device in the form of software, so as to facilitate the processor to call for the execution of the corresponding operation of each of the above modules.

In an embodiment, a computer device is provided, such as a terminal, and its internal structural diagram may be shown in FIG. 6. The computer device includes a processor connected via a system bus, a memory, a network interface, a display screen and an input device. The processor of the computer device is used to provide computing and control capabilities. The memory of the computer device includes a storage medium and an internal memory. The storage medium includes a non-volatile storage medium and/or a volatile storage medium. The storage medium stores an operating system and a computer program. The internal memory provides an environment for the operation of the operating system and the computer program in the storage medium. The computer device has a network interface for communicating with an external device via a network connection. The computer program is executed by a processor to implement a multi-ECU simulation test method.

In an embodiment, a computer device is provided, which includes a memory, a processor and a computer program stored on the memory and executable by the processor. When the computer programs are executed by the processor, the steps of the multi-ECU simulation test method of the above embodiments are implemented, such as steps 101-104 shown in FIG. 2 and other extensions of the method and related steps. Alternatively, when the computer programs are executed by the processor, the functions of each module/unit of the multi-ECU simulation test apparatus in the above embodiments are realized, such as the functions of modules 11-14 shown in FIG. 5, which are not repeated herein to avoid repetition.

The processor may be an ECU, a Central Processing Unit (CPU) or other general processors, a Digital Signal Processor (DSP), an Application Specific Integrated Circuit (ASIC), a Field-Programmable Gate Array (FPGA) or other programmable logic devices, discrete gates, transistor logic devices or discrete hardware components. The general processor may be a microprocessor or any conventional processor. The processor is a control center of the computer device and connects the parts of the entire computer device using various interfaces and circuits.

The memory may be used to store the computer programs and/or modules. The processor implements various functions of the computer device by running or executing the computer programs and/or modules stored in the memory, and by calling data stored in the memory. The memory mainly includes a program storage area and a data storage area. The program storage area may store an operating system, and applications required for at least one function (e.g. a sound playback function, an image playback function, etc.). The data storage area may store data (e.g. audio data, video data, etc.) created in accordance with the use of the mobile phone.

The memory may be integrated in the processor or may be provided separately from the processor.

In an embodiment, a computer readable storage medium having computer programs stored thereon is provided. When the computer programs are executed by a processor, the steps of the multi-ECU simulation test method of the above embodiments are executed, such as steps 101-104 shown in FIG. 2 and other extensions of the method and related steps. Alternatively, when the computer programs are executed by the processor, the functions of the modules/units of the multi-ECU simulation test apparatus in the above embodiment are implemented, such as the functions of modules 11-14 shown in FIG. 5, which will not be repeated herein to avoid repetition. In some embodiments, the computer-readable storage medium is a non-volatile computer-readable storage medium.

In an embodiment, a computer program product including computer programs is provided. When the computer programs are executed by a processor, the multi-ECU simulation test method in the above embodiments is implemented.

In an embodiment, a computer program including computer program codes is provided. When the computer program codes are run on a computer, the computer is caused to perform the multi-ECU simulation test method in the above embodiments.

It should be noted that the above explanatory description of the embodiments of the multi-ECU simulation test method is also applicable for the computer device, the non-volatile computer-readable storage medium, the computer program product, and the computer programs in the above embodiments, and will not be repeated herein.

Those skilled in the art understand that all or part of the processes in the methods of the above embodiments can be achieved by using computer programs to instruct relevant hardware. The computer programs are stored in a non-volatile and/or volatile computer-readable storage medium. When the computer programs are executed, the processes of the embodiments of the above methods can be implemented. Any reference to a memory, storage device, database or other mediums used in the embodiments of the disclosure may include a non-volatile and/or volatile memory. The non-volatile memory may include a Read-Only Memory (ROM), a programmable ROM (PROM), an electrically programmable ROM (EPROM), an electrically erasable programmable ROM (EEPROM) or a flash memory. The volatile memory may include a Random Access Memory (RAM) or an external cache memory. By way of illustration and not limitation, the RAM is available in a variety of forms, such as a static RAM (SRAM), a dynamic RAM (DRAM), a synchronous DRAM (SDRAM), a dual data rate SDRAM (DDRSDRAM), an enhanced SDRAM (ESDRAM), a Synchlink DRAM (SLDRAM), a Rambus Direct RAM (RDRAM), a Direct Rambus RAM (DRRAM), and a Rambus Dynamic RAM (RDRAM).

Those skilled in the art understand that, for the convenience and conciseness of the description, the classification of the above functional units and modules is illustrated by way of example. In actual application, the above functions can be assigned to be completed by different functional units and modules according to the needs. That is, the internal structure of the device can be divided into different functional units or modules, so as to complete the above-described functions in whole or in part.

The above-described embodiments are only used to illustrate the technical solutions of the disclosure and are not intended to limit it. Although the detailed description of the disclosure is provided with reference to the above-described embodiments, those skilled in the art should understand that the technical solutions recorded in the preceding embodiments can be modified, or a part of the technical features therein can be replaced by equivalences. These modifications or substitutions that do not make the essence of the corresponding technical solutions out of the spirit and scope of the technical solutions of the embodiments of the disclosure, shall be included in the scope of protection of the disclosure.

## Claims

1. A multi-electronic control unit (ECU) simulation test method, comprising:
obtaining a pre-developed application applied to a target ECU;
inputting the application into a pre-built multi-ECU simulation environment;
obtaining a target simulated ECU by querying a simulated vehicle-mounted ECU having a unique identifier the same as the target ECU in the multi-ECU simulation environment; and
simulating a communication process of the target simulated ECU via a simulated controller area network (CAN) or a simulated Internet network in the multi-ECU simulation environment, running the application based on the target simulated ECU, and outputting a running result of the application.

2. The method of claim 1, wherein pre-building the multi-ECU simulation environment, comprises:
configuring a data link layer and a physical layer of the simulated Internet network based on a received first instruction;
configuring a transport layer and a network layer of the simulated Internet network based on a received second instruction and an Internet protocol stack;
simulating a CAN bus communication based on a received third instruction and data distribution service; and
configuring virtual networks corresponding respectively to Internet protocol simulation addresses where the simulated vehicle-mounted ECUs are located based on a received fourth instruction.

3. The method of claim 1 or 2, wherein when there are a plurality of target ECUs to which the application is applied, and there is one Internet protocol address for the plurality of target ECUs, running the application based on the target simulated ECU, comprises:
obtaining a first message sent to the simulated CAN;
obtaining a simulated ECU of a sending object of the first message from the first message; and
replacing the first message with a source transmit code of a topic to which the simulated ECU of the sending object belongs.

4. The method of claim 1 or 2, wherein when there are a plurality of target ECUs to which the application is applied, and there are two or more Internet protocol addresses for the plurality of target ECUs, running the application based on the target simulated ECU, comprises:
obtaining a destination address of a second target simulated ECU in a simulated Internet network message sent by a first target simulated ECU;
converting the destination address to a target Internet protocol simulation address in the simulated Internet network; and
sending the simulated Internet network message to the second target simulated ECU corresponding to the target Internet protocol simulation address.

5. The method of any one of claims 1-4, wherein the application comprises a diagnostic file, running the application based on the target simulated ECU and outputting the running result of the application, comprises:
importing the diagnostic file into the target simulated ECU;
obtaining an execution result of executing the diagnostic file by the target simulated ECU; and
determining whether the execution result contains a diagnostic fault code or a corresponding error text, and if so, determining that the target simulated ECU is operating abnormally.

6. The method of any one of claims 1-4, wherein running the application based on the target simulated ECU and outputting the running result of the application, comprises:
importing the application into the target simulated ECU;
obtaining an execution result of executing the application by the target simulated ECU; and
outputting a function status parameter of the target simulated ECU carried in the execution result.

7. The method of any one of claims 1-6, wherein running the application based on the target simulated ECU, comprises:
parsing a first file in a Database CAN (DBC) format generated by the target simulated ECU based on the application; and
broadcasting a message generated based on the first file in the simulated CAN in accordance with an information cycle recorded in the first file.

8. A multi-electronic control unit (ECU) simulation test apparatus, comprising:
an application obtaining module, configured to obtain a pre-developed application applied to a target ECU;
an inputting module, configured to input the application into a pre-built multi-ECU simulation environment;
a querying module, configured to obtain a target simulated ECU by querying, in the multi-ECU simulation environment, a simulated vehicle-mounted ECU having a unique identifier the same as the target ECU; and
a running module, configured to simulate a communication process of the target simulated ECU via a simulated controller area network (CAN) or a simulated Internet network in the multi-ECU simulation environment, run the application based on the target simulated ECU, and output a running result of the application.

9. A computer device comprising a memory, a processor, and computer programs stored on the memory and executable by the processor, wherein when the computer programs are executed by the processor, steps of the multi-electronic control unit (ECU) simulation test method of any one of claims 1-7 are implemented.

10. A computer-readable storage medium having computer programs stored thereon, wherein when the computer programs are executed by a processor, steps of the multi-electronic control unit (ECU) simulation test method of any one of claims 1-7 are implemented.

11. A computer program product comprising computer programs, wherein when the computer programs are executed by a processor, the multi-electronic control unit (ECU) simulation test method of any one of claims 1-7 is implemented.

12. A computer program comprising computer program codes, wherein when the computer program codes are executed by a computer, the computer is caused to perform the multi-electronic control unit (ECU) simulation test method of any one of claims 1-7.
